# EUROPÄISCHE PATENTSCHRIFT

(11) **EP 2 130 213 B1**
(45) Veröffentlichungstag und Bekanntmachung des Hinweises auf die Patenterteilung: **05.04.2017**
(21) Anmeldenummer: 08715924.0
(22) Anmeldetag: 21.02.2008
(51) Int. Cl.: H01L 21/04, H01L 21/762, B29C 65/16, C03C 27/06, C04B 37/04

(54) **VERFAHREN ZUM LASER-GESTÜTZTEN BONDEN, UND DEREN VERWENDUNG**
METHOD FOR LASER SUPPORTED BONDING, AND USE THEREOF
PROCÉDÉ DE LIAISON PAR LASER, ET SON UTILISATION

(30) Priorität: 21.02.2007 DE 102007008540
(43) Veröffentlichungstag der Anmeldung: 09.12.2009
(73) Patentinhaber: Fraunhofer-Gesellschaft zur Förderung der angewandten Forschung e.V., 80686 München (DE); Friedrich-Schiller-Universität Jena, 07743 Jena (DE)
(72) Erfinder: TÜNNERMANN, Andreas, 99425 Weimar (DE); EBERHARDT, Ramona, 07751 Bucha (DE); KALKOWSKI, Gerhard, 07743 Jena (DE); NOLTE, Stefan, 07751 Jena (DE)
(74) Vertreter: Pfenning, Meinig & Partner mbB
(86) Internationale Anmeldenummer: PCT/EP2008/001362
(87) Internationale Veröffentlichungsnummer: WO 2008/101699

(56) Entgegenhaltungen:
- EP-A- 0 539 741
- EP-A- 0 621 130
- US-A1- 2004 082 145
- WITTE R ET AL: "Laser joining of glass with silicon" PROCEEDINGS OF THE SPIE, SPIE, BELLINGHAM, VA, Bd. 4637, 21. Januar 2002 (2002-01-21), Seiten 487-495, XP001156588 ISSN: 0277-786X
- GILLNER A ET AL: "LASER BONDING OF MICRO OPTICAL COMPONENTS" PROCEEDINGS OF THE SPIE, SPIE, BELLINGHAM, VA, Bd. 4941, 30. Oktober 2002 (2002-10-30), Seiten 112-120, XP001156860 ISSN: 0277-786X
- YANG H. T.; ZEHR S. W.: "Laser bonding for non-lattice matched STACKED CELLS" FIFTEENTH IEEE PHOTOVOLTAIC SPECIALISTS CONFERENCE - 12-15 MAY 1981, 1981, Seiten 1357-1362, XP008095018
- YOSHINO TOMOKI ET AL: "Energy-dependent temperature dynamics in femtosecond laser microprocessing clarified by Raman temperature measurement", ADVANCED FABRICATION TECHNOLOGIES FOR MICRO/NANO OPTICS AND PHOTONICS V, SPIE, 1000 20TH ST. BELLINGHAM WA 98225-6705 USA, vol. 8249, no. 1, 8 March 2012 (2012-03-08), pages 1-7, XP060023583, DOI: 10.1117/12.906969 [retrieved on 1901-01-01]
- TOMOKI YOSHINO ET AL: "In situ Micro-Raman Investigation of Spatio-Temporal Evolution of Heat in Ultrafast Laser Microprocessing of Glass", JAPANESE JOURNAL OF APPLIED PHYSICS, vol. 51, 27 October 2012 (2012-10-27), page 102403, XP055252236, JP ISSN: 0021-4922, DOI: 10.1143/JJAP.51.102403
- CHRIS B SCHAFFER ET AL: "Laser-induced breakdown and damage in bulk transparent materials induced by tightly focused femtosecond laser pulses; Laser-induced breakdown and damage to transparent materials", MEASUREMENT SCIENCE AND TECHNOLOGY, IOP, BRISTOL, GB, vol. 12, no. 11, 1 November 2001 (2001-11-01), pages 1784-1794, XP020063344, ISSN: 0957-0233, DOI: 10.1088/0957-0233/12/11/305

## Beschreibung

Die Erfindung betrifft ein Verfahren zum Laser-gestützten Bonden von Substraten, bei dem diese zunächst durch Anpressen kraftschlüssig miteinander verbunden werden und im Anschluss durch Laserstrahlung induzierte bereichsweise Aktivierung eine Verfestigung der Verbindung zwischen den Substraten erfolgt. Ebenso betrifft die Erfindung hiernach hergestellte Substrate.

Das aus dem Stand der Technik bekannte Direkt-Bonden oder Wafer-Bonden beruht auf dem Prinzip, dass Oberflächen mit einer ausreichenden Planarität aufgrund von Adhäsionskräften miteinander verbunden werden können. Dieses Direkt-Bonding erfolgt bei Temperaturen im Bereich von Raumtemperatur bis zum T_{G}-Punkt bzw. zum Schmelzpunkt. Derartige Verfahren sind beispielsweise aus der DE 197 52 412 A1 und der DE 100 48 374 A1 bekannt.

R. Witte et al. beschreiben in "Laser joining of glass with silicon", PROCEEDINGS OF THE SPIE, Bd. 4637, Seiten 487-495 die Möglichkeit des Verbindens einer Varietät von Materialien bei der Herstellung von Mikrosystemen.

A. Gillner et al. beschreiben in "Laser bonding of micro optical components", PROCEEDINGS OF THE SPIE, Bd. 4941, Seiten 112-120 die Möglichkeit des Verbindens von Silizium mit Glas durch selektives Laser-Erhitzen.

Aus der EP 0 539 741 A1 ist ein anodisches Fügeverfahren unter Lichtbestrahlung bekannt.

EP 0 621 130 A2 offenbart ein Verfahren zum Fügen von Verbindungen in der Festphase, das in einem Ultrahochvakuum ausgeführt wird.

US 2004/082145 A1 beschreibt ein Verfahren zum Fügen einer Silikonplatte an eine zweite Platte unter Laserbestrahlung.

H.T. Jung et al. beschreiben in "Laser bonding for non-lattice matched stacked cells", 15th IEEE PHOTO-VOLTAIC SPECIALISTS CONFERENCE, 1981, Seiten 1357-1362 ein Verfahren zum metallurgischen Fügen von Teilsolarzellen.

Allerdings liefert das Direkt-Bonding bei Raumtemperatur nur eine schwache Verbindung zwischen Substraten und muss üblicherweise durch nachträgliches Tempern bei erhöhten Temperaturen ergänzt werden, um ausreichende Haftfestigkeiten der gefügten Teile zu erzielen. So kann normalerweise erst bei Temperaturen von oberhalb 300 °C eine deutliche Zunahme der Haftkräfte und damit eine Verfestigung der Verbindung erzielt werden. Ein wesentlicher Nachteil der Temperaturbehandlung betrifft jedoch Substrate, die ein unterschiedliches thermisches Ausdehnungsverhalten aufweisen.

Aufgabe der vorliegenden Erfindung war es dabei, ein Verfahren zur Verbindung planarer Substrate bereitzustellen, das auch für thermisch wenig belastbare Materialien und Materialien mit unterschiedlichen Ausdehnungsverhalten einsetzbar ist und dennoch eine hohe Haftfestigkeit zwischen den Substraten ermöglicht.

Diese Aufgabe wird durch das Verfahren mit den Merkmalen des Anspruchs 1 gelöst. In den Ansprüchen 11 und 12 werden erfindungsgemäße Verwendungen angegeben. Die weiteren abhängigen Ansprüche zeigen vorteilhafte Weiterbildungen auf.

Erfindungsgemäß wird ein Verfahren zum Laser-gestützten Bonden von Substraten bereitgestellt, bei dem zwei Substrate in einem ersten Schritt durch unmittelbares Inkontaktbringen und gegebenenfalls Anpressen kraftschlüssig miteinander verbunden werden und im Anschluss eine Verfestigung der Verbindung zwischen den Substraten durch eine mit Laserstrahlung induzierte bereichsweise Aktivierung an der Grenzfläche zwischen den Substraten erfolgt. Selbstverständlich können auch mehr als zwei Substrate gemäß diesem Verfahren miteinander verbunden werden. Erfindungswesentlich bei dem genannten Verfahren ist die Verfestigung der Verbindung im zweiten Schritt, die durch Laserstrahlung induziert wird, wobei jedoch die Laserenergie so gewählt wird, dass die Schmelz- bzw. Transformationstemperatur der Substrate bei der Aktivierung nicht erreicht wird. Dadurch dass die Schmelztemperatur nicht erreicht wird, bleibt die Form der Oberfläche der Substrate unverändert erhalten.

Es tritt kein Übergang von der festen in die flüssige Phase ein, sondern die zugeführte Energie wird in elektronische Anregung der Oberflächen-Atome/Moleküle umgesetzt. Dabei tritt eine Anregung von Elektronen aus den besetzten Orbitalen im Grundzustand in unbesetzte Orbitale im angeregten Zustand ein. Hiermit verbunden ist eine hohe chemische Reaktivität, die zur Ausbildung von neuen chemischen Bindungen an den Berührungsstellen der beiden Substrate führen kann. Durch Relaxation der elektronischen Anregungszustände wird auch Energie in das Festkörpergitter transferiert, das über Schwingungsanregung der Oberflächen zur weiteren Annäherung der benachbarten Substrate und Ausbildung von neuen chemischen Bindungen (Reaktionen) zwischen den Oberflächen-Atomen/Molekülen der beiden Substrate führen kann.

Erfindungsgemäß wird durch die Laserstrahlung eine chemische Anregung von Molekülen und/oder Atomen in mindestens einem der Substrate im Bereich der Grenzfläche ermöglicht.

Erfindungsgemäß ist die Laserstrahlung gepulst, um einen definierten Energieeintrag in die Substrate zu ermöglichen.

Erfindungsgemäß erfolgt eine starke Fokussierung der Laserstrahlung auf die Grenzfläche.

Die erfindungsgemäße Verfahrensführung erfolgt dabei wie nachfolgend beschrieben.

Es wird die Wellenlänge der Laserstrahlung so abgestimmt und die Fokussierung der Laserstrahlung so gewählt, dass das erste Substrat durchstrahlt wird und anschließend eine Anregung von Bindungszuständen der Moleküle und/oder Atome von mindestens einem Substrat nur im Bereich der Grenzfläche erfolgt. Eine genaue Lokalisierung wird hierbei dadurch ermöglicht, dass die Laserstrahlung auf definierte Bereiche fokussiert wird. Die Aktivierungsenergie und damit auch der Grad der Verfestigung der Verbindung zwischen den Substraten kann über die Parameter Fokussierung, Pulsenergie, Pulswiederholrate und Anzahl der Pulse der Laserstrahlung eingestellt werden.

Hierbei werden Substrate, die bei einer Wellenlänge λₐ im wesentlichen transparent sind, mit langwelliger, nicht linear absorbierender Laserstrahlung der Wellenlänge λ ≥ λₐ bestrahlt. Durch eine entsprechend starke Fokussierung der Laserstrahlung auf die Grenzfläche kommt es zu Mehrphotonenprozessen, wenn eine genügend hohe Intensität der Laserstrahlung erreichat wird. Die Aktivierungsenergie und damit der Grad der Verfestigung dieser Form der Verbindung lässt sich über die Fokussierung, die Pulsdauer, die Pulsenergie, die Pulswiederholrate und die Anzahl der Pulse der Laserstrahlung einstellen.

Anstatt eines Lasers können auch mehrere Laser mit unterschiedlichen Wellenlängen λ_{Laser1}, λ_{Laser2}, λ_{Laser3} usw. verwendet werden, die allesamt größer λₐ sind

Die Steuerung des resultierenden Wärmeeintrags erfolgt über die geeignete Wahl der Fokussierung, der Wellenlänge, der Pulsdauer, der Pulsenergie sowie der Pulswiederholrate und der Dauer der Bestrahlung, d.h. der Anzahl der Pulse. Der Wärmetransport und damit das erwärmte Volumen hingen dabei stark von der Pulsdauer ab. Bei Verwendung ultrakurzer Pulse, d.h. im Piko- bis Femto-Sekundenbereich, kann eine große Wärmeausbreitung vermieden werden. Bei hoher Pulsfolgefrequenz kann es dennoch zu Wärmeakkumulation kommen. In diesem Fall wird die Temperatur sukzessive mit der Anzahl der Pulse erhöht. Allerdings kann das erwärmte Gebiet dadurch auch größer als der Fokus werden.

Als Substrate können sowohl amorphe, teilkristalline oder kristalline Substrate eingesetzt werden. Aus der Gruppe der amorphen Substrate sind Gläser, insbesondere Siliziumdioxid, bevorzugt. Als teilkristalline Substrate werden vorzugsweise Glaskeramiken, z.B. Zerodur^{®} oder ULE^{®}, eingesetzt. Die kristallinen Substrate sind bevorzugt ausgewählt aus der Gruppe bestehend aus Halbleitern, Keramiken, Piezokeramiken, nicht-linearen optischen Kristallen. Als Halbleiter sind hier insbesondere Silizium, Indiumphosphid oder Galiumarsenid bevorzugt. Unter den Piezokeramiken sind Bariumtitanat oder Bleizirkonattitanat besonders Gebiet dadurch auch größer als der Fokus werden.

Als Substrate können sowohl amorphe, teilkristalline oder kristalline Substrate eingesetzt werden. Aus der Gruppe der amorphen Substrate sind Gläser, insbesondere Siliziumdioxid, bevorzugt. Als teilkristalline Substrate werden vorzugsweise Glaskeramiken, z.B. Zerodur^{®} oder ULE^{®}, eingesetzt. Die kristallinen Substrate sind bevorzugt ausgewählt aus der Gruppe bestehend aus Halbleitern, Keramiken, Piezokeramiken, nicht-linearen optischen Kristallen. Als Halbleiter sind hier insbesondere Silizium, Indiumphosphid oder Galiumarsenid bevorzugt. Unter den Piezokeramiken sind Bariumtitanat oder Bleizirkonattitanat besonders bevorzugt. Als nichtlineare optische Kristalle kommen insbesondere Kaliumtitanylphosphat, Lithiumniobat, Bariumdiborat oder Lithiumtriborat zum Einsatz. Ebenso können als Substrate Kunststoffe eingesetzt werden. Aus der Gruppe der Kunststoffe sind hier insbesondere Polymethylmethacrylat, Polycarbonat oder Polymere und Copolymere von Cycloolefinen sowie deren Verbundwerkstoffe bevorzugt.

Das erfindungsgemäße Verfahren eignet sich insbesondere für den Fall, dass zwei unterschiedliche Substrate eingesetzt werden. Hierbei kann es sich insbesondere um Substrate mit unterschiedlichen thermischen Ausdehnungskoeffizienten handeln. Es ist aber ebenso möglich, dass zwei Substrate aus dem gleichen Material eingesetzt werden. Hinsichtlich der Substrate sind solche mit möglichst planarer Oberfläche einzusetzen.

Die Anforderungen an die Ebenheit und Rauhigkeit hängen vom Substratmaterial und seiner Flexibilität ab. Grundsätzlich steigen die Ebenheitsanforderungen mit zunehmender Biegesteifigkeit des Substrats, insbesondere mit zunehmender Substrathöhe, merklich an.

Für das Bonden von zwei Glassubstraten mit jeweils einer Höhe von ca. 1 mm sollte die lokale Ebenheit über einen Flächenausschnitt von etwa 20 mm * 20 mm, vorzugsweise etwa 10 nm (PV= Peak To Valley) oder besser sein. Dieser Wert stellt aber lediglich einen groben Anhaltspunkt dar. Abweichungen von etwa einer Größenordnung nach unten oder oben sind je nach Material, Substrathöhe und Prozessführung (Anpressdruck etc.) möglich. Grundsätzlich kann bei geringeren Substrathöhen eine höhere Unebenheit toleriert werden.

Die Rauhigkeit der Oberfläche sollte vorzugsweise ≤ 1 nm betragen (RMS= Root Mean Square), wenigstens aber ≤ 5 nm (RMS).

Derartige Voraussetzungen an die Planarität der Oberfläche können, wenn nicht von Anfang an gegeben, z.B. durch vorgelagerte Bearbeitungs- und Reinigungsschritte zur Entfernung von Partikeln und Schmutz erreicht werden. Als weitere Vorbehandlungsschritte kommen auch eine Plasmaaktivierung der Oberflächen, z.B. eine Nieder- oder Hochdruckplasma-Behandlung mit Stickstoff, Sauerstoff, Wasserstoff oder Argon sowie die Adsorption funktioneller Gruppen, z.B. SO₂, NH₃, an der Oberfläche in Frage. Alle hier genannten Vorbehandlungsschritte, d.h. die Reinigung, die Plasmaaktivierung und die Adsorption funktioneller Gruppen können in beliebiger Reihenfolge durchgeführt werden.

Ebenso ist es möglich, dass das erfindungsgemäße Verfahren in einem integrierten Aufbau abläuft, in dem das Bonden und die anschließende Laser-Aktivierung zur Ausschaltung von zwischenzeitlichen Umwelteinflüssen in derselben Anlage, besonders bevorzugt im Vakuum, oder auch unter Schutzgas, durchgeführt werden.

Weiterhin ist es bevorzugt, durch die Laser-Aktivierung benachbarter Bereiche linien- oder flächenförmige Verfestigung der Verbindung zwischen den Substraten zu realisieren.

Eine bevorzugte Variante des erfindungsgemäßen Verfahrens sieht vor, dass das Bonden durch das bekannte Direkt-Bonding mit den Prozessschritten der Reinigung des Substrats, der Plasma-Aktivierung der Substratoberfläche und des Aufeinanderpressens der Substrate durchgeführt wird.

Eine Variante des erfindungsgemäßen Verfahrens sieht vor, dass zwei glatte, ebene Substrate unmittelbar aufeinander gelegt werden, so dass die Abstände zwischen den beiden Substraten zum Teil atomare Dimensionen annehmen, d.h. bis zu 1 nm. Vorzugsweise kann dies über Direct-Bonding erfolgen, es besteht aber ebenso die Möglichkeit bei hinreichend kleinen, ebenen und sauberen Flächen durch bloßes Aufeinanderlegen und Anpressen bzw. Ansprengen, wie es in der Optik praktiziert wird, hinreichend kleine Abstände zu erzielen.

In einem zweiten Schritt wird dann Laserstrahlung auf die Grenzfläche fokussiert, wodurch diese möglichst genau an der Grenzfläche ihre höchste Intensität erreicht.

Durch Fokussierung der Laserstrahlung auf die Grenzfläche zwischen den Substraten wird die Intensität dort so hoch, dass dort eine nicht-lineare Absorption eintritt. Diese ist auf Mehrphotonenprozesse, d.h. die Kombination von zwei oder mehr Photonen zurückzuführen. Eine nicht-lineare Absorption ist die Kombination mehrerer Photonen gleicher Wellenlänge oder die Kombination mehrerer Photonen unterschiedlicher Wellenlänge, die zur Überwindung einer Energielücke führt, die für jedes einzelne Photon unüberwindbar wäre. Derartige Absorptionsprozesse sind intensitätsabhängig. So sind 2-Photonenprozesse proportional zum Quadrat der Intensität, 3-Photonenprozesse proportional zur dritten Potenz der Intensität usw.. Die nicht-lineare Absorption ist somit von den Fokussierungsbedingungen bzw. der Intensität der Laserstrahlung im Fokus abhängig. Zusätzlich gehen materialspezifische Einflussfaktoren, wie z.B. die lokale Kristallsymmetrie, ein. Bei hoher Intensität der Laser-Strahlung ist außer Mehrphotonenabsorption auch eine Beeinflussung der elektronischen Struktur der Substrate möglich, z.B. Bandverbiegung, energetische Verschiebung von Grenzflächenzuständen, welche die Absorption und damit den Energieeintrag in das Material u.U. begünstigen kann. Zu beachten ist darüber hinaus, dass einmal in das Leitungsband angeregte Elektronen sehr effizient weitere Laser-Strahlung absorbieren und über Stoßprozesse ihre Energie schnell an die Substrate abgeben können.

Welche Laser-Intensität für nichtlineare Absorption in Gläsern erforderlich ist und wie eine ausreichende Intensität erzielt werden kann, ist z.B. aus C. Schaffer et al., "Laser-induced breakdown and damage in bulk transparent materials induced by tightly focused femtosecond laser pulses", Meas. Sci. Technol. 12(2001), 1784-1794, bekannt. Bei einer Pulsdauer von ca. 100 fs und einer Wellenlänge von 800 nm liegt die Intensitäts-Schwelle für den optischen Durchbruch (d.h. wenn so viele Elektronen aus dem Valenzband in das Leitungsband angeregt wurden, dass das Glas nicht mehr transparent ist) in der Größenordnung von 10¹³ W/cm².

Das zitierte Beispiel soll aber nur einen ungefähren Anhaltspunkt liefern. Eine ausreichende Aktivierung kann durchaus bei weniger freigesetzten Elektronen stattfinden, d.h. bereits bei ein bis zwei Größenordnungen geringerer Intensität erfolgen. Zudem kann die Bandlücke durch Defekte, Oberflächenbindungen etc. geringer sein. Darüber hinaus muss man beachten, dass bei einigen speziellen Materialien, z.B. bei Farbstoffen, die ja in den Substraten enthalten sein können, bereits Intensitäten von kW/cm² ausreichen können.

Somit ist der in der obigen Druckschrift beschriebene Weg nur einer zur experimentellen Realisierung der erforderlichen Intensität. Für den Sachkundigen der Lasertechnologie sind vielfältige Variationen der Einstellparameter unmittelbar selbstverständlich, die zu einer vergleichbaren Intensität, bzw. ähnlichem Energieeintrag durch Absorption führen.

Beschrieben werden ebenso gebondete Substrate, die nach dem zuvor beschriebenen Verfahren hergestellt wurden.

Das erfindungsgemäße Verfahren findet unter anderem bei der Herstellung von Hochleistungskomponenten zur Strahlformung Anwendung. Hierunter ist sowohl die Ablenkung, die Streuung als auch die Fokussierung von Strahlung zu verstehen. Typische Anwendungen aus diesem Bereich sind das Fügen von Prismen oder das Verschließen von Gittern. Eine weitere erfindungsgemäße Verwendung betrifft die Herstellung von klebstofffreien Präzisionsverbindungen. Hierunter sind mechanisch stabile Verbindungen ohne anorganische bzw. organische Zwischenschicht zu verstehen. Ebenso fallen hierunter elektrooptische Modulatoren.

Ein weiteres Beispiel für eine erfindungsgemäße Verwendung betrifft die sog. hybride Integration. Unter hybrider Integration ist die Verbindung unterschiedlicher Materialien zu einer funktionalen Einheit zu verstehen. Dies betrifft z.B. die Verbindung von Silicium (Mikroelektronik) und GaAs (Optik) zu opto-elektronischen Bauelementen. Aber auch die Verbindung von opto-elektronischen Bauelementen mit strukturierten Elementen aus Glas oder transparentem Kunststoff (Mikrolinsenarrays) oder bereits die Verbindung von optischen Glas- und Kunststoffelementen ist unter dem Begriff hybrider Integration zu subsumieren. Ein wesentliches Problem bei der hybriden Integration ist häufig die unterschiedliche thermische Ausdehnung der beteiligten Materialien, die eine entsprechend angepasste konstruktive Gestaltung der Verbindung erfordert.

Anhand der nachfolgenden Figuren soll das erfindungsgemäße Verfahren näher erläutert werden, ohne dieses auf die hier gezeigten speziellen Ausführungsformen einschränken zu wollen.
Fig. 1 zeigt anhand einer schematischen Darstellung, wie Laserstrahlung auf die Grenzfläche der Substrate fokussiert wird.
Fig. 2 zeigen schematische Darstellungen der energetischen Verhältnisse außerhalb des Fokus bzw. bei niedriger Laserintensität für eine eingestrahlte Laser-Wellenlänge (a) bzw. für zwei unterschiedliche Laser-Wellenlängen (b).
Fig. 3 zeigt eine schematische Darstellung der energetischen Verhältnisse innerhalb des Fokus bzw. bei hoher Laserintensität für eine eingestrahlte Laser-Wellenlänge (a) bzw. für zwei unterschiedliche Laser-Wellenlängen (b).
Fig. 4 zeigt beispielhaft eine erste Oberflächenreaktion der mit dem Laser aktivierten Substrate.
Fig. 5 zeigt beispielhaft eine zweite Variante für eine Oberflächenreaktion der mit dem Laser aktivierten Substrate.

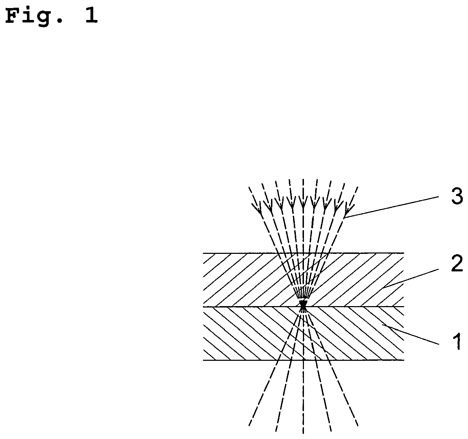

Die Fokussierung der Laserstrahlung ist schematisch in Fig. 1 dargestellt, wobei die Laserstrahlung 3 zunächst das Substrat 2 passiert und an der Grenzfläche zum Substrat 1 fokussiert wird.

Die Laserstrahlung durchdringt das erste Substrat, weil sie langwelliger, d.h. niederenergetischer ist, als für eine lineare Absorption nötig. Das bedeutet, dass die Photonenenergie nicht für die Überwindung der Energielücke zwischen Valenzband und Leitungsband des Substratmaterials ausreicht. Somit ist das Substrat 2 transparent für die Laserstrahlung auf der eingestrahlten Wellenlänge.

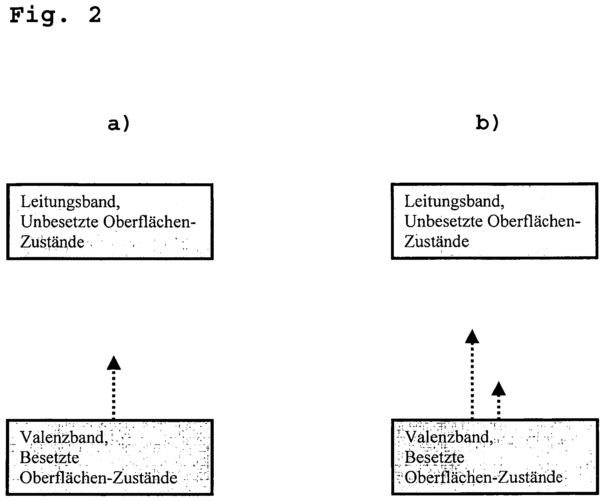

In Fig. 2a) und 2b) ist schematisch dargestellt, dass die hier eingestrahlten Laserwellenlängen (skizziert durch Pfeile) nicht ausreichen, um die Lücke zwischen beiden Bändern, also den besetzten und den unbesetzten Zustand, zu überwinden.

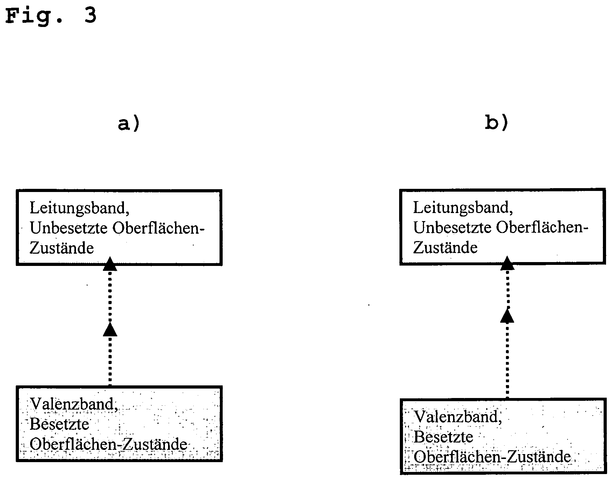

In Fig. 3a) und 3b) sind die energetischen Verhältnisse innerhalb des Fokus bei einer einzigen eingestrahlten Laser-Wellenlänge (Fig. 3a)) und bei zwei unterschiedlichen Laser-Wellenlängen (Fig. 3b)) dargestellt. Die Kombination der Photonenenergien reicht aus um die Energielücke zwischen den besetzten und den unbesetzten Zuständen zu überwinden. Es findet eine nicht-lineare Absorption und Energieeintrag in der Grenzfläche statt.

Der angeregte Zustand führt zu einer chemischen Reaktion, welche die Bindungsverhältnisse zwischen den Substraten verändert und letztlich zu einer stärkeren Bindung/Haftung der Substrate aneinander führt.

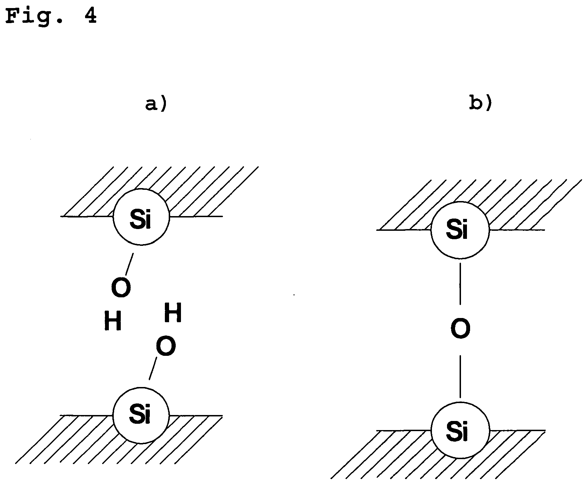

In Fig. 4 sind mögliche Oberflächenreaktionen der mit dem Laser aktivierten Substrate dargestellt. Hierbei zeigt Fig. 4a) die Oberfläche eines Glases vor der Aktivierung mit Laserstrahlung. So sind Silicium-Valenzen an der Oberfläche eines Glases häufig zunächst durch OH-Gruppen abgesättigt, d.h. das Glas besitzt hydrophilen Charakter. Durch die Laseraktivierung wird eine chemische Reaktion eingeleitet, die zu einer Sauerstoffbrückenbindung zwischen den Silicium-Atomen in Form einer stabilen kovalenten Bindung und Kondensation von Wasser führt (Fig. 4b)). Das entstehende H₂O-Molekül kann z.B. durch Diffusion zunächst aus der Grenzfläche wegtransportiert werden und nach außen gelangen bzw. an anderer Stelle weiter reagieren.

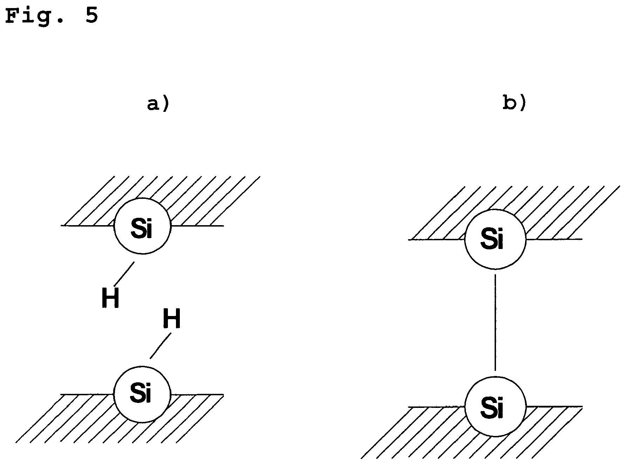

In Fig. 5 ist eine zweite beispielhafte Oberflächenreaktion dargestellt. Hierbei zeigt Fig. 5a) die Oberfläche eines Glases, das durch H-Atome abgesättigt ist vor der Aktivierung mit der Laserstrahlung. Das Glas ist hier hydrophob. Durch die Laseraktivierung wird eine Abspaltung der H-Atome eingeleitet und zwei benachbarte Si-Atome reagieren direkt miteinander unter Ausbildung einer kovalenten Si-Si-Bindung (stabile kovalente Bindung). Das entstehende H₂-Molekül kann entsprechend durch Diffusion aus der Grenzfläche wegtransportiert werden und nach außen gelangen bzw. an anderer Stelle weiter reagieren.

Analoge Reaktionen sind nicht nur für OH oder H, sondern auch für andere Funktionalgruppen an der Oberfläche denkbar. Entsprechend sind auch andere Substrat-Materialien neben Silicium geeignet.

## Patentansprüche

1. Verfahren zum Laser-gestützten Bonden von Substraten, bei dem zwei Substrate durch unmittelbares Inkontaktbringen miteinander verbunden werden und im Anschluss eine Verfestigung der Verbindung zwischen den Substraten durch eine mit Laserstrahlung induzierte bereichsweise Aktivierung an der Grenzfläche zwischen den Substraten erfolgt, wobei die Schmelz- bzw. Transformationstemperatur der Substrate bei der Aktivierung nicht erreicht wird, **dadurch gekennzeichnet, dass** die Laserstrahlung auf die Grenzfläche zwischen den Substraten fokussiert wird, gepulst ist und durch die Laserstrahlung eine chemische Anregung der Moleküle und/oder Atome mindestens eines Substrats im Bereich der Grenzfläche erfolgt, wobei die Wellenlänge der Laserstrahlung auf mindestens ein Substrat abgestimmt und die Fokussierung der Laserstrahlung so gewählt wird, dass eine Anregung von Bindungszuständen der Moleküle und/oder Atome von mindestens einem Substrat gezielt im Bereich der Grenzfläche erfolgt und die Aktivierungsenergie und damit der Grad der Verfestigung der Verbindung über die Fokussierung, Pulsenergie, Pulswiederholrate und die Anzahl der Pulse der Laserstrahlung eingestellt wird, wobei
zwei für eine eingestrahlte Laserstrahlung mit der Wellenlänge λₐ im wesentlichen transparente Substrate eingesetzt werden, und diese mit Laserstrahlung langwelliger, nicht linear absorbierender Wellenlänge λ, wobei gilt λ ≥ λₐ bestrahlt werden, und durch starke Fokussierung Mehrphotonenprozessen bei entsprechend hoher Intensität der Laserstrahlung ausgelöst werden und die Aktivierungsenergie und damit der Grad der Verfestigung der Verbindung über die Fokussierung, Wellenlänge, Pulsdauer, Pulsenergie, Pulswiederholrate und die Anzahl der Pulse der Laserstrahlung eingestellt wird.

2. Verfahren nach Anspruch 1, **dadurch gekennzeichnet, dass** die Substrate amorph, teilkristallin und/oder kristallin sind, wobei die amorphen Substrate bevorzugt ausgewählt sind aus der Gruppe der Gläser, insbesondere Siliziumdioxid, als teilkristalline Substrate Glaskeramiken eingesetzt werden und als kristalline Substrate Halbleiter, Keramiken, Piezokeramiken und/oder nichtlineare optische Kristalle eingesetzt werden.

3. Verfahren nach einem der vorhergehenden Ansprüche, **dadurch gekennzeichnet, dass** als Substrate Kunststoffe, insbesondere Polymethylmethacrylat, Polycarbonat oder Polymere und Copolymere von Cycloolefinen sowie deren Verbundwerkstoffe eingesetzt werden.

4. Verfahren nach einem der vorhergehenden Ansprüche, **dadurch gekennzeichnet, dass** zwei unterschiedliche Substrate, insbesondere mit einem unterschiedlichen thermischen Ausdehnungskoeffizienten, oder zwei Substrate aus dem gleichen Material eingesetzt werden.

5. Verfahren nach einem der vorhergehenden Ansprüche, **dadurch gekennzeichnet, dass** die Substrate durch Anpressen kraftschlüssig verbunden werden.

6. Verfahren nach einem der vorhergehenden Ansprüche, **dadurch gekennzeichnet, dass** die Laser-Aktivierung in Schutzgasatmosphäre oder im Vakuum durchgeführt wird.

7. Verfahren nach einem der vorhergehenden Ansprüche, **dadurch gekennzeichnet, dass** die zu verbindenden Oberflächen der Substrate zuvor gereinigt werden und/oder zuvor eine Plasma-Aktivierung der zu verbindenden Oberflächen der Substrate erfolgt und/oder zuvor eine Funktionalisierung der zu verbindenden Oberflächen der Substrate erfolgt.

8. Verfahren nach einem der vorhergehenden Ansprüche, **dadurch gekennzeichnet, dass** durch Aktivierung benachbarter Bereiche linienoder flächenförmige Verfestigungen erfolgen.

9. Verfahren nach einem der vorhergehenden Ansprüche, **dadurch gekennzeichnet, dass** das Bonden durch Direkt-Bonding mit den Prozessschritten Reinigung, Plasma-Aktivierung und Anpressen erfolgt.

10. Verfahren nach einem der vorhergehenden Ansprüche, **dadurch gekennzeichnet, dass** alle Verfahrensschritte in derselben Anlage durchgeführt werden.

11. Verwendung des Verfahrens nach einem der Ansprüche 1 bis 10 für die Herstellung von Hochleistungskomponenten zur Strahlformung, insbesondere die Ablenkung, Streuung und Fokussierung von Strahlung.

12. Verwendung des Verfahrens nach einem der Ansprüche 1 bis 10 für die Herstellung von Präzisionsverbindungen.

## Claims

1. A method for the laser-assisted bonding of substrates, in which two substrates are joined together by being brought directly into contact, and subsequently strengthening of the join between the substrates takes place by activation in regions, induced by laser radiation, at the interface between the substrates, wherein the melting or transformation temperature of the substrates is not reached during the activation, **characterised in that** the laser radiation is focused onto the interface between the substrates, is pulsed and chemical excitation of the molecules and/or atoms of at least one substrate takes place in the region of the interface due to the laser radiation, the wavelength of the laser radiation being matched to at least one substrate and the focusing of the laser radiation being selected such that excitation of binding states of the molecules and/or atoms of at least one substrate takes place in targeted manner in the region of the interface, and the activation energy and hence the degree of strengthening of the join is set by means of the focusing, pulse energy, pulse repetition rate and the number of pulses of the laser radiation,
two substrates which are substantially transparent to a radiated laser radiation of the wavelength λₐ being used, and these being irradiated with laser radiation of long-wave, non-linearly absorbing wavelength λ, wherein λ ≥ λₐ, and by precise focusing multiphoton processes are triggered at a corresponding high intensity of the laser radiation, and the activation energy and hence the degree of strengthening of the join is set by means of the focusing, wavelength, pulse duration, pulse energy, pulse repetition rate and the number of pulses of the laser radiation.

2. A method according to Claim 1, **characterised in that** the substrates are amorphous, partially crystalline and/or crystalline, the amorphous substrates preferably being selected from the group of glasses, in particular silicon dioxide, glass ceramics are used as partially crystalline substrates and semiconductors, ceramics, piezoceramics and/or non-linear optical crystals are used as crystalline substrates.

3. A method according to one of the preceding claims, **characterised in that** plastics materials, in particular polymethyl methacrylate, polycarbonate or polymers and copolymers of cycloolefins and also composite materials thereof are used as substrates.

4. A method according to one of the preceding claims, **characterised in that** two different substrates, in particular with different coefficients of thermal expansion, or two substrates made of the same material are used.

5. A method according to one of the preceding claims, **characterised in that** the substrates are joined in non-positive manner by pressing together.

6. A method according to one of the preceding claims, **characterised in that** the laser activation is carried out in a protective gas atmosphere or in a vacuum.

7. A method according to one of the preceding claims, **characterised in that** the surfaces of the substrates which are to be joined are cleaned beforehand and/or plasma activation of the surfaces of the substrates which are to be joined takes place beforehand and/or functionalisation of the surfaces of the substrates which are to be joined takes place beforehand.

8. A method according to one of the preceding claims, **characterised in that** linear or two-dimensional strengthening takes place by activation of neighbouring regions.

9. A method according to one of the preceding claims, **characterised in that** the bonding takes place by direct bonding with the process steps cleaning, plasma activation and pressing together.

10. A method according to one of the preceding claims, **characterised in that** all the method steps are carried out in the same installation.

11. Use of the method according to one of Claims 1 to 10 for the production of high-performance components for beam formation, in particular the deflection, scattering and focusing of radiation.

12. Use of the method according to one of Claims 1 to 10 for the production of precision joins.

## Revendications

1. Procédé de liaison de substrats assistée par laser, dans lequel deux substrats sont reliés entre eux par une mise en contact directe et ensuite a lieu une solidification de la liaison entre les substrats à l'aide d'une activation partielle induite par un rayon laser au niveau de l'interface entre les substrats, la température de fusion ou de transformation des substrats n'étant pas atteinte lors de l'activation, **caractérisé en ce que** le rayon laser est focalisé sur l'interface entre les substrats, est pulsé et le rayon laser provoque une excitation chimique des molécules et/ou des atomes d'au moins un substrat au niveau de l'interface, la longueur d'onde du rayon laser étant adaptée à au moins un substrat et la focalisation du rayon laser étant choisie de façon à ce qu'une excitation des états de liaison des molécules et/ou des atomes d'au moins un substrat a lieu de manière ciblée au niveau de l'interface et l'énergie d'activation, et donc le degré de solidification de la liaison est régulé par l'intermédiaire de la focalisation, de l'énergie d'impulsion, de la fréquence de répétition des impulsions et du nombre d'impulsions du rayon laser,
deux substrats globalement transparents pour un rayon laser avec la longueur d'onde λₐ sont utilisés et ceux-ci sont irradiés avec un rayon laser d'une longueur d'onde plus importante, non absorbante de manière linéaire, A, dans lequel λ ≥ λₐ, et une forte focalisation permet de déclencher des processus à plusieurs photons dans le cas d'une intensité supérieure correspondante du rayon laser et l'énergie d'activation et donc le degré de solidification de la liaison est réglé au moyen de la focalisation, de la longueur d'onde, de la durée d'impulsion, de l'énergie d'impulsion, de la fréquence de répétition des impulsions et du nombre d'impulsions du rayon laser.

2. Procédé selon la revendication 1, **caractérisé en ce que** les substrats sont amorphes, partiellement cristallins et/ou cristallins, les substrats amorphes étant sélectionnés de préférence parmi le groupe des verres, plus particulièrement le dioxyde de silicium, en tant que substrats partiellement cristallins, des céramiques vitreuses étant utilisées et des semi-conducteurs, des céramiques, des piézo-céramiques et/ou des cristaux optiques non linéaires étant utilisés en tant que substrats cristallins.

3. Procédé selon l'une des revendications précédentes, **caractérisé en ce que**, en tant que substrats, des matières plastiques, plus particulièrement du polyméthylméthacrylate, du polycarbonate ou des polymères et des copolymères de cyclooléfines ainsi que leurs composites sont utilisés.

4. Procédé selon l'une des revendications précédentes, **caractérisé en ce que** deux substrats différents, plus particulièrement dotés de coefficients de dilatation thermique différents, ou deux substrats constitués du même matériau sont utilisés.

5. Procédé selon l'une des revendications précédentes, **caractérisé en ce que** les substrats sont reliés de force par pressage.

6. Procédé selon l'une des revendications précédentes, **caractérisé en ce que** l'activation par laser est effectuée dans une atmosphère à gaz de protection ou dans le vide.

7. Procédé selon l'une des revendications précédentes, **caractérisé en ce que** les surfaces à relier des substrats sont auparavant nettoyées et/ou auparavant une activation par plasma des surfaces des substrats à relier est effectuée et/ou auparavant une fonctionnalisation des surfaces des substrats à relier est effectuée.

8. Procédé selon l'une des revendications précédentes, **caractérisé en ce que** l'activation de zones adjacentes permet des solidifications linéaires ou planes.

9. Procédé selon l'une des revendications précédentes, **caractérisé en ce que** la liaison a lieu par liaison directe avec les étapes de nettoyage, d'activation par plasma et de pressage.

10. Procédé selon l'une des revendications précédentes, **caractérisé en ce que** toutes les étapes du procédé ont lieu dans une seule et même installation.

11. Utilisation du procédé selon l'une des revendications 1 à 10 afin de fabriquer des composants haute performance pour former un rayon, plus particulièrement le dévier, le diffuser et le focaliser.

12. Utilisation du procédé selon l'une des revendications 1 à 10 pour la fabrication de liaisons de précision.
